# EUROPEAN PATENT APPLICATION

(11) **EP 1 424 156 A1**
(43) Date of publication of application: **02.06.2004**
(21) Application number: 02026648.2
(22) Date of filing: 29.11.2002
(51) Int. Cl.: B23K 1/005, B23K 33/00

(54) **Process for soldering miniaturized components onto a base plate**

(71) Applicant: Leica Geosystems AG, 9435 Heerbrugg (CH)
(72) Inventor: Rossopoulus, Stephane, 1412 Ursin (CH); Verettas, Irène, 1007 Lausanne (CH); Clavel, Reymond, 1377 Oulens/Echallens (CH)
(74) Representative: Kaminski, Susanne, Dr.

(57) **Abstract**

The invention relates to a process for fastening a miniaturized component (2) having a wettable bottom side (4) on a base plate (1) by a solder joint, wherein the base plate (1) is coated on one side with a continuous layer of metal (5), a soldering material (6) is placed on the coated side of the base plate (1), the component (2) is arranged above the soldering material (6), the soldering material (6) and the bottom side (4) of the component (2) facing the base plate (1) being a vertical distance apart and not in contact with one another, and a laser beam is supplied from the opposite side of the coated side of the base plate (1) for melting the soldering material (6), after which a contact between the bottom side (4) of the component (2) and the melted soldering material (6) is made for mutual fastening. Either the not melted soldering material (6) forms a flat lump, before the laser beam is supplied, which upon melting becomes a drop with the result that the drop of soldering material (6) fills the space between the bottom side (4) of the component (2) and the base plate (1) and wets the surface of the bottom side (4) of the component (2) or the soldering material (6) forms a continuous spot of a multiple area than the surface of the bottom side (4) of the component (2) and after melting of a circumscribed part of said spot facing the bottom side (4) of the component (2), the component (2) is dipped into the melted soldering material (6), wetting the surface of the bottom side (4) of the component (2), whereupon the component (2) is lifted back to its previous determined position the soldering material (6) bonding to the surface of the bottom side (4) of the component (2).

## Description

### Technical Area of the Invention

The present invention relates to high precision assembly of miniaturized components by soldering the components on a base plate. In particular the invention relates to a laser soldering process of micro-optical components on a base plate which is transparent for laser beams and covered by a metallization and a base plate obtained by such a process.

### Background of the Invention

Methods of micro soldering components by using laser beams are known from the prior art.

WO 99/26754 describes a process for fastening a miniaturized component on a base plate by a solder joint. The soldering material either coats the bottom side of the component or is placed on the base plate. The base plate is coated with a grid-like metal pattern. The component is held a distance apart from the base plate without contact with the base plate. Heat energy is then supplied from the bottom side of the base plate for melting the soldering material until a drop is formed. A part of the power goes through the holes of the grid and heats the soldering material. A second part of the power heats the metal layer and a last part is reflected. The component and the base plate are mutually fixed to each other when the drop of soldering material fills the gap between them and the solder material is solidified.

Due to the grid-like metal pattern on the base plate a critical adjustment of the light absorption coefficient of the metal layer is necessary not to overheat or under-heat the base plate. The metallized grid normally covers about 70 % of the surface of the base plate and only less than 30 % of the power of the laser beam is used to heat the soldering material, whereas one part of the remaining 70% heats up the base plate and the other part of power is reflected. Such a process requires more than 15 W for 2 seconds to realize a soldering. Further, the kind of metal layer has to be different depending on the chosen material of base plate. Moreover, a discrete effect appears due to the grid-like pattern, when the soldering material wets the metal layer and the soldering stops at lines defined by the holes of the grid.

It has been observed that during the soldering process, the soldering material close to the lateral sides of the component colds down much faster than the rest of the soldering material which may result in an asymmetry of the solidified soldering material. The assembly technique is based on the soldering of two different materials. The difference in the coefficient of thermal expansion between the soldering material and the base plate induces a remarkable stress at the interface after the soldering process. Depending on the mechanical resistance of the carrier material, a parasitic local bending at the location of the solder joints may occur due to the current stress.

By the above process an accuracy of about 2 microns along the six degrees of freedom can be obtained. However a higher accuracy is strongly desired, in particular for components holding micro-optical elements. Hence, the necessity to improve the process to achieve a high accuracy for the assembling of miniaturized components, in particular small optical components, on a base plate remains, still.

Further, fluxless and/or lead less soldering is scarcely feasible in the process described above. It has been observed that the use of fluxless solder of Sn96Ag4 and a metal layer coated with tin, nickel and gold leads to a satisfying result only in combination with a continuous metal layer. However when a grid-like metal pattern is used, like in the process described above, the fixation is unsatisfactory because of an insufficient wettability of the grid.

### Summary of the Invention

It is the object of the present invention to provide an alternative process for joining a component with a base plate by soldering which permits an improved accurate positioning.

According to the invention a base plate is coated with a continuous metal layer, both together forming a substrate, a soldering material is placed on the metal layer of the substrate, the component is arranged above the soldering material, the soldering material and the bottom side of the component facing the base plate being a vertical distance apart and not in contact with one another, after which heat energy, e.g. a laser beam, is supplied from the side reverse to the coated side of the base plate for melting the soldering material and a contact between the bottom side of the component and the melted soldering material is made for mutual fastening.

Due to the continuous metal layer the accuracy of the final fixation of the component on the base plate is superior to the process of WO 99/26754, because the wetting of a continuous layer is much easier and more homogenous. Therefore, fluxless and/or leadless soldering is feasible.

Further, the high adsorption coefficient of the metal layer results in a 40% reduction compared with the process of WO 99/26754 of the laser power to be applied for the soldering. Thus, a laser power of less than 10 W for 2 seconds may be sufficient for the soldering. The lower quantity of power transferred from the laser beam into the assembly reduces the danger of a damage to optical elements housed by the component markedly. In particular, the metal layer better absorbs the laser beam. This further allows to select alloys with higher melting temperatures. For the process of the present invention the absorption coefficient of the metal layer has to be only maximized to be able to solder on different types of base plates, whereas the soldering power of the laser needs to be adjusted only for adapting to the thermal conductivity of the base plate.

As the process of the present inventions applies a continuous layer of metal, no grid-like pattern has to be provided which reduces the production costs of the base plate considerably.

In one embodiment of the invention the soldering material is placed on the metal layer in the form of a flat lump and a component is aligned above the soldering material. An energy source, e.g. laser, is aligned below the base plate under the component and executes a vertical energy shot from below. The energy goes through the base plate and hits the metal layer on the upper side of the base plate. The metal layer is locally heated and acts like a heating plate for the solder. Then the soldering lump melts and takes the shape of a drop, because of the surface tension of the liquid soldering material, and expands up some hundreds of microns until it hits the bottom side of the component and wets it.

Alternatively, the component is dipped into the melted part of the soldering material, wetting the surface of the bottom side of the component, whereupon the component is lifted back to its previous determined position with soldering material bonding to the surface of the bottom side of the component, after which the soldering material is solidified. In this embodiment the soldering material can be placed on the metal layer and/or on the bottom side of the component.

In another embodiment of the invention the soldering material is at least in a part of said base plate discretely, e.g. dot-like, or continuously coated on the metal layer of the base plate. After an energy source, e.g. a laser, is aligned with the component, an energy shot, e.g. laser shot, is executed from below the base plate. The energy, e.g. laser beam, goes through the base plate and heats a circumscribed part of the metal layer. Thus, a small portion of the soldering material is molten which is directly localized under the component. Then the component is moved down to touch the liquid soldering material, after which the wetted component is lifted up again to its previous position with soldering material bonding to the surface of the bottom side of the component.

In a further embodiment of the invention a small lump is placed on the base plate which cross-sectional area is smaller than the cross-sectional area of the component, so that the projection of the bottom side of the component on the base plate overlaps the cross-sectional area of the not melted soldering lump before the heat is applied. The reduction of the cross-sectional area of the solder lump further increases the accuracy.

The soldering process according to the invention has an accuracy of fastening in the region of 0.25 micron. Thus, the process is particularly suitable for fastening small, optical components.

### Short Description of the Drawings

- Fig. 1 a, 1 b: show the alignment of the component with the soldering material and the substrate before (1a) and after (1b) the soldering, wherein the diameter d1 of the lump of soldering material is smaller than the diameter D of the bottom side of the component.
- Fig. 2a, 2b: show the alignment of the component with the soldering material and the substrate before (2a) and after (2b) the soldering, wherein the diameter d2 of the lump of soldering material is substantially the same than the diameter D of the bottom side of the component.
- Fig. 3: shows the determination of the diameter d of the lump of the soldering material if the component is tilted αₘₐₓ = ± 5 deg.
- Fig. 4a, 4b: show a component and a substrate that is dot-like coated with the soldering material before (4a) and after the soldering (4b).
- Fig. 5a, 5b: show a component and a substrate that is continuously coated with the soldering material before (5a) and after (5b) the soldering.

### Detailed Description of the Invention

The bottom side, i.e. the base, of the component must have a good wettability for the soldering material.

The bottom side of the component might be flat or convex, for example curved spherically outward or curved cylindrically outward. A round bottom side simplifies a pitch and roll adjustment, because of the geometrical symmetry. Since rotational symmetry of the solder joint is present between the bottom side of the component and the base plate, this permits stable, mechanical properties of the solder joint in any configuration, which is important for good repeatability of the process due the symmetrical force distribution.

An energy source is aligned below the base plate with the component and after the activation the energy flows through the base plate in order to heat the layer of metal. The base plate should have a good transmittance for the wavelengths used. The base plate and the metal layer together form the substrate.

The material which is used for producing the base plate should withstand thermal shocks since, if the energy, e.g. a laser beam, is passed through the base plate, part of the energy carried is absorbed by a local region of the base plate coating, which region is consequently subjected to a rapid temperature increase. The coating should be a material which normally should have a good conductivity, usually a metal, so that it transmits to the base plate a certain quantity of energy which causes a local and marked temperature increase. In the case of a base plate which is suitably characterized by poor thermal conductivity - for example glass, ceramic or glass ceramic - the energy remains concentrated in a local part of the base plate, which can readily result in the base plate breaking owing to temperature gradients which are present. Also of importance is the fact that temperature changes can change the mutual spacings of the components and possibly their focal distances, so that it is essential for the material of the base plate to have a low coefficient of thermal expansion. The base plate may be made, for example, of glass, sapphire, ceramics, glass ceramics or silicium.

The layer of metal may be formed by a plurality of layers and be covered with an anti-oxidizing coating.

In one embodiment of the invention the base plate is a piece of a sapphire or a Pyrex wafer with a thickness around 1 and 2 millimetres. This wafer is covered by the metal layer made out of chrome, nickel and gold. This metal layer has a thickness of around one micron. The lump material - SnPb or Sn96Ag4 - is filling a gap of 0.2 to 0.5 millimetres between the substrate and the component.

Shrinkage of the soldering material during the cooling phase for fastening unavoidably changes the component adjustment along the vertical axis. The shrinkage exhibits very good repeatability and can be calibrated as a function of the space between the base plate and the bottom side of the component. One solution for overcoming this vertical shrinkage is to automatically compensate it before beginning or during the soldering process, i.e. for example to take the magnitude of the shrinkage into account in the design.

In a further embodiment of the invention the assembly accuracy might be further increased, especially when the component is tilted, by reducing the cross-sectional area of the soldering material, i.e. the diameter of the flat lump. In this case the diameter d of the flat lump is smaller than the diameter D of the bottom side of the component. At least after fixation the smallest diameter of the solidified lump is smaller that the diameter D. The advantage of this provision is that it limits the asymmetry of the rapid cooling effect close to the lateral parts of the component, therefore improving the assembly accuracy due to a symmetrical joint. When the component is soldered when being tilted, the solder joint is more symmetric, too, because of the smaller quantity of soldering material used, which improves the assembling accuracy in the tilted case, too. Finally the stress caused by different thermal expansion coefficients is smaller, since the expanding surfaces being in contact are smaller, therefore the parasitic local bending of the substrate is reduced as well as of the component, which also improves the assembling accuracy.

The process is suitable, particularly, for use in automatic assembly stations by a flux-free and precise laser soldering method, since all required functions can be performed by robots which are provided with positioning sensors. Each component is positioned and fixed in the space by a robot, along the six degrees of freedom.

This technique is particularly suitable for adjusting and fastening micro-optical parts along six degrees of freedom with high accuracy. For this application the component holds a micro-optical element, such as, for example, lens, optical fibres, laser diodes, etc. The component forms a housing in which the optical elements are fastened. Such components might have, for example, a diameter of 2,6 mm and a height of 3,5 mm. Suitable examples of components holding a micro-optical elements according to the present invention are described in EP 1127287 B1.

In another embodiment of the invention at least one component as described above which holds an optical element is fastened to a base plate by a solder joint. The base plate has to be transparent to electromagnetic waves, in particular to laser beams. The upper side of the base plate on which the solder joint is placed is coated with a continuous layer of metal. As the component may be secured at a predetermined position during the solidifying of the soldering material, e.g. by a gripper of a robotic station, the shrinkage of the soldering material may result in a concave shape of the peripheral area of the solder joint.

In a particular embodiment of the present invention the component comprises a holding houses which holds a support part with an optical element, wherein the support part with the fastened optical element is fixed to the holding house by two welding points as described in EP 1127287 B1.

The subject of the invention is explained in more detail below on the basis of examples and with reference to drawings.

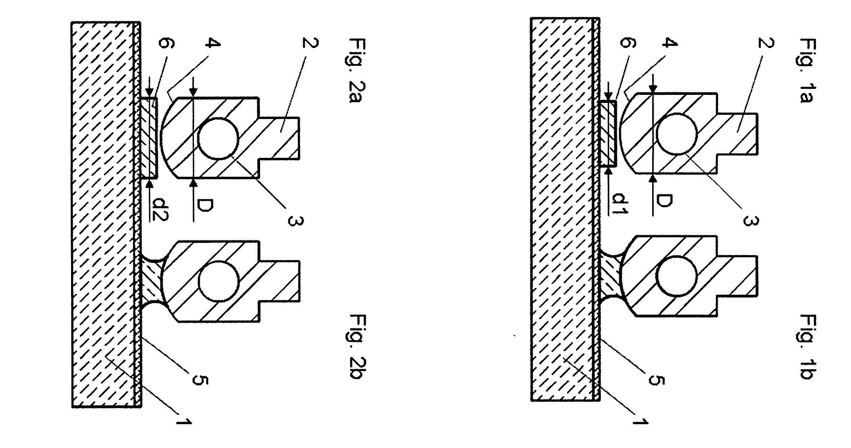

Fig. 1 a and 2a show a base plate 1 with a component 2 which is arranged above it. The component 2 is composed of two parts: a holding housing and a support part for an optical element, wherein the support part is fixed to the holding house by two welding points. The support part comprises a hole 3 for the passage of a light beam. The bottom side 4 of the component 2 is formed with a convex surface. The base plate 1 is transparent for laser beams and the upper surface of the base plate 1 is continuously coated with a thin metal layer 5. The base plate 1 and the metal layer 5 form the substrate. Soldering material in the form of a flat lump 6 is placed on the metal layer 5 facing the bottom side 4 of the component 2 without having contact with each other.

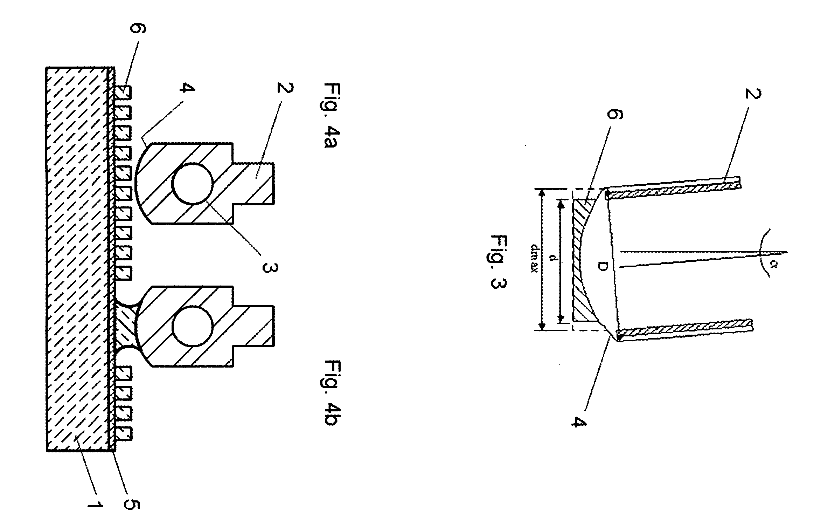

The component 2 is hold by a robotic station (not shown) over the base plate 1. During a first phase the component 2 is aligned with the soldering lump 6 with a very high accuracy. There is a small gap of air between the soldering lump 6 and the bottom side 4 of the component 2. When the right position is reached, a laser source is aligned with the component 2 and a vertical laser shot is executed from below the base plate 1. This laser goes through the transparent base plate 1 and hits the layer of metal 5 on the base plate 1. The laser heats locally the metal layer which acts like a heating plate for the lump 6. The lump 6 heats up until it melts. Because of the surface tension of the liquid soldering material, the lump 6 takes the shape of a drop and fills up the gap between the base plate 1 and the bottom side 4 of the component. The liquid soldering material hits the bottom side 4 of the component 2 and wets it. After that the laser is turned off and the soldering material solidifies again obtaining the fixation of the component 2 onto the base plate 1. In Fig. 1a the diameter d1 of the flat lump 6 is smaller that the diameter D of the bottom side 4 of the component 2, whereas in Fig. 2a the diameter d2 of the flat lump 6 is substantially the same that the diameter D of the bottom side 4 of the component 2. Fig. 1 band 2b show the state after melting of the soldering material 6, a joint with the metal layer 5 of the base plate 1 being produced by bridging the space between the metal layer 5 and the bottom side 4 of the component 2. In both cases after fixation - Fig. 1 b, 2b - the smallest diameter of the solidified lump 6 is smaller the diameter of the bottom side 4 of the component 2.

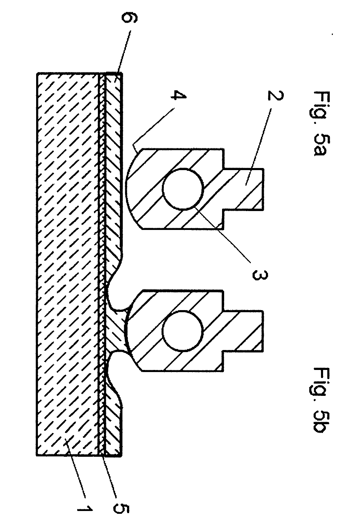

Fig. 3 explains the determination of the diameter d of a small lump 6 in the case when the component 2 is tilted αₘₐₓ = ± 5 deg. With the diameter of the bottom side 4, for example D=2,6 mm, the radius of curvature r=1,6 mm of the bottom side 4, and in case of a tilt αₘₐₓ = ± 5 deg the maximum diameter d of a lump 6, getting into close contact with the bottom side 4, can be calculated as dₘₐₓ=2,43mm in this case. The size of the diameter d of the small lump 6 is derived from the requirement that the soldering material should not get into close contact with the bottom side 4, also in extreme situations with a large tilt of the component 2. In order to fulfil this requirement, the diameter d of the small lump 6 is selected as dₘₐₓ reduced by 20% or d=2,43*(1-0,2)=1,94 mm, then.

Fig. 4a and 4b show a component 4 and a substrate 1, 5 that is dot-like coated with soldering material 6 before - Fig. 4a - and after - Fig. 4b - the soldering. The laser heats locally the metal layer 5 which acts like a heating plate and the dots of soldering material 6 melt together.

Fig. 5a and 5b show a component 4 and a substrate 1, 5 that is continuously coated with soldering material 6, before and after the soldering.

## Claims

1. A process for fastening a miniaturized component (2) having a wettable bottom side (4) on a base plate (1) by a solder joint, wherein
- the base plate (1) is coated on one side with at least one layer of metal (5),
- a soldering material (6) is placed on the coated side of the base plate (1) and/or on the bottom side (4) of the component (2),
- the component (2) is arranged above the soldering material (6), the soldering material (6) and the bottom side (4) of the component (2) facing the base plate (1) being a vertical distance apart and not in contact with one another, and
- heat energy is supplied from the reverse side to the coated side of the base plate (1) for melting the soldering material (6), after which a contact between the bottom side (4) of the component (2) and the melted soldering material (6) is made for mutual fastening
**characterized in that**
the layer of metal (5) is continuous.

2. The process according to claim 1, wherein the bottom side (4) of the component (2) is convex.

3. The process according to claim 2, wherein the bottom side (4) of the component (2) is curved spherically outward or curved cylindrically outward.

4. The process according to anyone of the claims 1 to 3, wherein the base plate (1) is transparent to electromagnetic waves.

5. The process according to anyone of the claims 1 to 4, wherein a beam of electromagnetic waves is directed through the base plate (1) onto the layer of metal (5) for heating the soldering material (6) until it melts.

6. The process according to claim 5, wherein the beam is a laser light beam.

7. The process according to claim 6, wherein a laser power of less than 20 W during 2 s is applied.

8. The process according to anyone of the claims 1 to 7, wherein the projection of the bottom side (4) of the component (2) on the base plate (1) overlaps the cross-sectional area of the not melted soldering material (6), before the bottom side (4) of the component (2) is brought into contact with the soldering material (6).

9. The process according to anyone of the claims 1 to 8, wherein the not melted soldering material (6) forms a flat lump, before heat energy is supplied, which upon melting becomes a drop with the result that the drop of soldering material (6) fills the space between the bottom side (4) of the component (2) and the base plate (1) and wets the surface of the bottom side (4) of the component (2) for mutual fastening.

10. The process according to anyone of the claims 1 to 7, wherein the soldering material (6) forms a continuous or discrete spot of a multiple area than the surface of the bottom side (4) of the component (2) and after melting of a circumscribed part of said spot facing the bottom side (4) of the component (2) which is arranged in a defined position above the soldering material (6), the component (2) is dipped into said melted part of the soldering material (6), wetting the surface of the bottom side (4) of the component (2), whereupon the component (2) is lifted back to its previous determined position with soldering material (6) bonding to the surface of the bottom side (4) of the component (2), after which the soldering material (6) is solidified.

11. A base plate (1) with at least one component (2) which holds especially an optical element and is fastened to one side of the base plate (1) by a solder joint, wherein the base plate (1) is transparent to electromagnetic waves and is at least partly coated with a layer of metal (5) on the side of the solder joint,
**characterized in that**
the layer of metal (5) is continuous.

12. The base plate (1) according to claim 11, wherein the peripheral area of the solder joint is concave.

13. The base plate (1) according to claim 11 or 12, wherein the bottom side (4) of the component (2) is convex.

14. The base plate (1) according to anyone of the claims 11 to 13, wherein the component (2) comprises a housing which holds a support part, the optical element being fastened to the support part and the support part is fixed to the holding house by two welding points.

15. A substrate for use in the process as to anyone of the claims 1 to 10, comprising a base plate (1) which is transparent to electromagnetic waves, the base plate (1) being coated on at least a part of one side by at least one continuous layer of metal (5).

16. The substrate according to claim 15, wherein a soldering material (6) is placed dot-like or continuously on at least a part of the coated side of the base plate.

17. A component (2) for holding an optical element for use in the process as to anyone of the claims 1 to 10, having a convex bottom side, preferably being curved spherically outward or curved cylindrically outward.

18. The component (2) according to claim 17, wherein solder material is applied to the bottom side (4) of the component (2).
